## Europäisches Patentamt
## European Patent Office
## Office européen des brevets

(19)

(11) Numéro de publication: **0 025 763 B1**

---

(12) # FASCICULE DE BREVET EUROPEEN

(45) Date de publication du fascicule du brevet:
**25.04.84**

(51) Int. Cl.³: **H 03 K 17/94 // B60K37/00**

(21) Numéro de dépôt: **80401308.4**

(22) Date de dépôt: **12.09.80**

(54) Tableau de commande avec contacts à effleurement.

(30) Priorité: **12:09.79 DE 2936815**

(43) Date de publication de la demande:
**25.03.81 Bulletin 81/12**

(45) Mention de la délivrance du brevet:
**25.04.84 Bulletin 84/17**

(84) Etats contractants désignés:
**BE DE FR GB IT LU NL SE**

(56) Documents cités:
**DE - A - 2 517 030
FR - A - 2 374 811
FR - A - 2 427 741
GB - A - 1 246 296
GB - A - 1 334 544
US - A - 3 372 789
US - A - 3 673 327**

(73) Titulaire: **SAINT-GOBAIN VITRAGE, Les
Miroirs 18, avenue d'Alsace, F-92400 Courbevoie (FR)**

(84) Etats contractants désignés: **BE FR GB IT LU NL SE**

(73) Titulaire: **VEGLA Vereinigte Glaswerke GmbH, Viktoria
Allee 3-5, D-5100 Aachen (DE)**

(84) Etats contractants désignés: **DE**

(72) Inventeur: **Sauer, Gerd, Karl Friedrich Strasse 25,
D-5100 Aachen-Laurensberg (DE)**

(74) Mandataire: **Eudes, Marcel et al, Saint-Gobain
Recherche 39 Quai Lucien Lefranc, F-93304 Aubervilliers
Cedex (FR)**

---

## Tableau de commande avec contacts à effleurement

L'invention a pour objet un tableau de commande constitué d'une plaque de verre munie de contacteurs à effleurement à rayonnement infrarouge placés en regard de repères imprimés signalant les touches de ces contacteurs.

Des tableaux de commande de ce type sont connus, par exemple par la publication de brevet anglaise GB-A-1 246 296.

Dans le cas en question, les contacteurs à effleurement associent côte à côte, sur la face arrière d'une plaque transparente, un émetteur, et un récepteur à rayonnement infrarouge relié à un circuit de commande.

Des fenêtres transparentes à ce seul rayonnement sont prévues devant ces ensembles à l'intérieur de chaque touche; en regard de chaque fenêtre, le rayonnement de l'émetteur atteint la face antérieure tournée vers l'utilisateur, de sorte qu'il se trouvera réfléchi ou diffusé par effleurement de la plage de contact, et le détecteur excité par la lumière retransmise.

L'invention a pour objet de fournir un tableau de commande analogue mais de structure simplifiée car il ne possèdera qu'un émetteur pour plusieurs récepteurs. Elle utilise à cette fin le phénomène de réflexion totale à l'intérieur d'une plaque de verre éclairée par la tranche. A plusieurs détecteurs placés chacun en regard de sa propre fenêtre, derrière la plaque, elle associe donc un émetteur unique éclairant le chant de cette dernière.

On peut noter à cet égard que le brevet US-A-3 673 327 utilise, dans un autre domaine, un principe quelque peu comparable: une plaque rectangulaire transparente constituant un écran frontal devant un tube cathodique, une série d'émetteurs modulés placés sur deux côtés consécutifs de cette plaque dirigent des faisceaux étroits vers des récepteurs situés un à un en face de chacun d'eux. On constitue ainsi une matrice cartésienne et l'interruption simultanée de deux faisceaux orthogonaux en leur point d'intersection ou leur simple perturbation en ce point par le contact d'un doigt sur la face externe de la plaque provoque l'émission d'un signal caractéristique des coordonnées du point en question.

Selon la présente invention, au contraire, la perturbation locale de la seule réflexion totale du rayonnement diffus d'un émetteur infrarouge, généralement unique, suffit à engendrer transversalement un signal capable d'exciter un détecteur placé en face du point d'action.

Il devient donc possible de simplifier et de rendre beaucoup plus économique la construction du panneau de contacteurs à effleurement à rayonnement infrarouge, en en conservant tous les avantages.

Les éléments semi-conducteurs sensibles au rayonnement infrarouge sont avantageusement des phototransistors. Pour réduire sa sensibilité à la lumière parasite, la fenêtre derrière laquelle se trouve chacun d'eux est munie, de préférence sur sa face arrière, d'un filtre transparent au rayonnement infrarouge mais qui arrête le rayonnement visible.

Comme il n'existe ainsi ni orifice à travers la plaque de verre ni, sur sa face avant, organe jouant un rôle dans le contacteur, on obtient la meilleure protection contre les détériorations et les attaques atmosphériques. Ces tableaux de commande sont donc particulièrement adaptés aux dispositfs qui travaillent dans des locaux très humides tels que cuisines, laveries, etc ... ou qui, pour d'autres raisons, sont au contact de l'eau ou de l'humidité. On pourra d'autre part former leur plaque avant de verre trempé de façon à obtenir une bonne sécurité aux chocs, en particulier sur des véhicules.

On peut aussi placer à l'arrière d'un tableau de commande suivant l'invention des organs indicateurs électro-optiques; ceci permet d'étendre le champ d'utilisation aux cas dans lesquels de tels organes sont utiles, voire nécessaires.

Les inscriptions et marques nécessaires, par exemple pour le repérage des plages sensibles, sont avantageusement placées sur la face avant de la plaque de verre. Pour les rendre visibles dans l'obscurité, on peut éclairer le bord de la plaque au moyen de lumière visible, ce qui fait apparaître les marques à l'observateur par suite de la diffusion lumineuse dans l'épaisseur du verre.

Selon une caractéristique de l'invention, on peut alors utiliser un émetteur donnant, en plus de la lumière visible, suffisamment de rayonnement infrarouge pour pouvoir à la fois fournir le rayonnement infrarouge capable d'activer les détecteurs et le rayonnement visible servant à illuminer les repères.

Des exemples avantageux de mise en œuvre de l'invention sont décrits ci-dessous, en référence aux dessins. Ces dessins montrent:

figure 1: une coupe transversale partielle d'un tableau de bord selon l'invention,

figure 2: un exemple de mise en œuvre de l'invention sur un tableau de bord de véhicule automobile.

Le tableau de bord est constitué d'une plaque 1 de verre silicate, avantageusement trempé par voie thermique pour augmenter sa résistance aux chocs et sa capacité de flexion.

Sur sa face avant tournée vers l'utilisateur, il porte des repères 2, formés dans le cas décrit par un cadre entourant la plage sensible à l'intérieur de laquelle il faut toucher la plaque de verre 1 pour agir sur le contact choisi. Les repères 2 sont constitués par exemple d'une couche de laque blanche cuite au four. Sur la face arrière, la plaque 1 porte une couche opaque 3, constituée d'une laque noire mate, cuite au four, et destinée à éviter ou du moins à réduire autant que possible les réflexions gênantes qui pouraient se produire sur cette face.

La couche 3 s'interrompt à l'intérieur de la plage repérée par les marques 2 pour former une fenêtre 4 à travers laquelle peuvent passer les rayons infrarouges.

A l'emplacement de cette fenêtre est placée une couche filtrante 5 opaque à la lumière visible mais transparente au rayonnement infrarouge. Pour fabriquer une telle couche filtrante, on peut utiliser, par exemple, en raison de leurs caractéristiques de transmission particulières, des céments à l'argent du commerce. La couche filtrante 5, aussi bien que la couche opaque 3 et les repères 2 peuvent être déposés par impression à l'aide de couleurs du commerce, par exemple à l'écran de soie, sur la feuille de verre froide puis, après séchage, y être incorporés par cuisson.

On choisit avantageusement des émaux cuisant à des températures de l'ordre de 600°C. Pour constituer les repères 2, on peut, par exemple, utiliser un émail céramique blanc tel que l'émail 19 710 de la firme DEGUSSA. Pour ce qui est de la couche opaque 3, à l'arrière de la plaque de verre, on pourra employer l'émail noir mat 39 307 de la firme BLYTHE COLOURS N.V. Enfin, pour fabriquer la couche filtrante 5, on choisira par exemple le cément à l'argent 73 008, propre à l'impression, de DEGUSSA.

On chauffe la plaque de verre jusqu'à la température de trempe pour cuire les laques, puis on lui fait immédiatement subir une trempe thermique par refroidissement brusque, par soufflage d'air ou à l'aide d'un autre mode de refroidissement.

Derrière la couche filtrante 5 et en regard de la fenêtre 4 est placé un phototransistor 6 sensible aux rayons infrarouges.

Selon l'invention, l'éclairage par le rayonnement infrarouge n'est pas dirigé normalement sur la plage sensible à travers la fenêtre 4 mais injecté dans la plaque de verre 1 à l'aide d'un émetteur 7 assorti d'un réflecteur 8 et placé en regard du chant 9. L'émetteur 7 est ainsi capable d'exciter un nombre important de récepteurs. Dans cet exemple, il s'agit d'une source à large spectre lumineux qui, en plus de la lumière infrarouge nécessaire pour exciter les transistors récepteurs 6 par diffusion lorsqu'on pose un doigt sur la plage sensible, fournit aussi de la lumière visible. Cette lumière provoque une illumination des repères 2 qui, par diffusion, les rend visibles à l'observateur, ce qui dispense d'un éclairage externe du tableau de commande.

Les émetteurs infrarouge sont avantageusement excités à fréquence donnée par des impulsions très courtes de l'ordre de la microseconde, et fournissent ainsi des éclairs de relativement grande puissance. Le circuit de détection commandé par les transistors récepteurs est conçu de façon que seules les impulsions de fréquence correspondant à la fréquence d'émission sont amplifiées, ce qui augmente la sécurité d'emploi. Sur la face arrière de la plaque de verre et à l'intérieur d'un cadre de repérage, un dispositif indicateur annexe, électrique ou électronique, peut encore s'ajouter au contact à effleurement. Cette disposition groupée fournit un contrôle simple et efficace de l'état des diverses commandes.

Une petite lentille 10 fait que seuls les rayons pénétrant perpendiculairement seront reçus et, pour éviter les effets perturbateurs que la diffusion des rayons infrarouges sur les repères 2 pourrait provoquer, le cadre formé par ces derniers est placé à l'extérieur du champ d'action du transistor. Cela signifie que son contour interne est extérieur à celui de la fenêtre 4 dans la couche opaque 3.

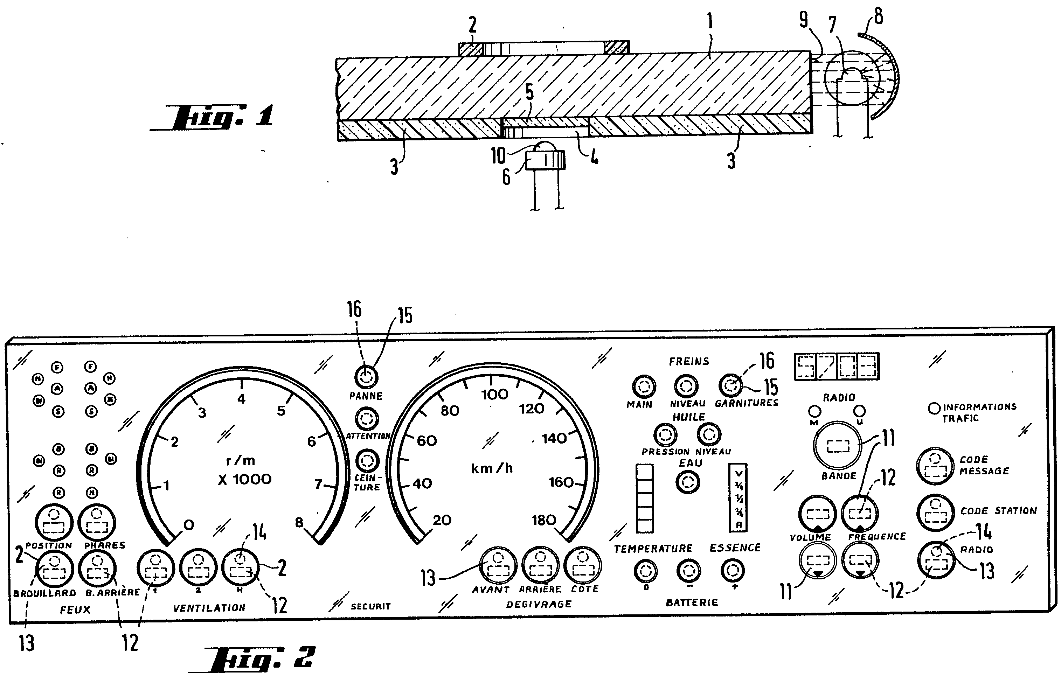

La figure 2 représente, à titre d'exemple d'une utilisation préférée du tableau de commande selon l'invention, une planche de bord de véhicule automobile.

Cette planche possède pour les différents dispositifs électriques tels qu'éclairage, ventilation, chauffage, désembuage, radio, etc ... une série de touches sensibles à effleurement équipées de contacteurs du type décrit ci-dessus, délimitées par des cadres imprimés 2.

Pour les contacteurs qui n'exigent pas de contrôle optique, par exemple pour les réglages de fréquence et de volume des récepteurs radiophoniques, sont prévues des touches sensibles 11 exclusivement munies d'un contacteur à effleurement.

A l'emplacement de chaque touche 11, la fenêtre pratiquée dans la couche opaque à l'arrière de la feuille de verre forme un champ rectangulaire 12, derrière lequel se trouve le transistor récepteur.

Dans le cas des touches sensibles 13 pour lesquelles un contrôle optique est utile, s'y ajoute, au-dessus, une fenêtre ronde plus petite 14 derrière laquelle est placé un indicateur lumineux électrique ou électronique qui, en s'allumant, renseigne sur l'état du circuit.

D'autre part, il existe aussi sur la face avant de la plaque de verre une série de repères 15 à l'intérieur desquels, sur la face arrière, des fenêtres circulaires de plus petite dimension, 16 qui ne reçoivent que des lampes de contrôle, sont réservées dans les couches opaques. Ces lampes sont indépendantes des capteurs sensibles mais servent aux contrôles des paramètres de fonctionnement les plus variés du véhicule.

**Revendications**

1. Tableau de commande constitué d'une plaque de verre (1) munie de contacteurs à effleurement placés en regard de repères imprimés (2) qui en signalent les touches, lesdits contacteurs comprenant des détecteurs semi-conducteurs sensibles au rayonnement infrarouge, placés derrière des fenêtres (4) transparentes au rayonnement infra-rouge pratiquées en regard desdites plages imprimées dans un masque (3) situé sur la face arrière de la plaque de verre, caractérisé en ce qu'un ensemble au moins de plusieurs détecteurs (6) est associé à un même émetteur infra-rouge (7) placé en regard d'un chant (9) de la plaque de verre, à l'intérieur de laquelle il injecte le rayonnement infra-rouge, qui s'y propage par réflexion totale.

2. Tableau de commande selon la revendication 1, caractérisé en ce que le masque (3) sur la face arrière de la plaque de verre (1) est constitué d'une couche d'un émail opaque vitrifié.

3. Tableau de commande selon la revendication 2, caractérisé en ce que, sur les fenêtres, est placé un filtre infra-rouge constitué d'une couche imprimée (5), en particulier un cément à l'argent, cuite au four sur la face arrière.

4. Tableau de commande selon la revendication 3, caractérisé en ce que les inscriptions et repères (2) sont constitués d'un émail blanc imprimé sur la face avant.

5. Tableau de commande selon l'une des revendications 1 à 4, caractérisé en ce que plaque de verre (1) est une plaque de verre silicate trempée thermiquement, à la surface de laquelle la couche opaque (3), la couche filtrante (5) et les repères (2) sont incorporés par cuisson en une seule fois lors du traitement thermique destiné à la trempe.

6. Tableau de commande selon les revendications 1 à 5, caractérisé en ce qu'un émetteur de lumière visible est placé sur son chant face au bord de la plaque de verre pour en illuminer les repères par diffusion.

7. Tableau de commande selon la revendication 6, caractérisé en ce que c'est l'émetteur de lumière visible qui constitue en même temps l'émetteur infra-rouge.

**Patentansprüche**

1. Schalttafel aus einer Glasplatte (1) mit Berührungsschaltern, die innerhalb von aufgedruckten, die Berührungsfelder anzeigenden Markierungen (2) angeordnet sind, und die für Infrarotstrahlen empfindliche Halbleiter-Empfänger umfassen, die hinter für Infrarotstrahlen durchlässigen, in einer Maske (3) auf der Rückseite der Glasplatte innerhalb der aufgedruckten Markierungen liegenden Fenstern (4) angeordnet sind, dadurch gekennzeichnet, daß wenigstens mehrere Empfänger (6) gemeinsam ein und demselben Infrarotsender (7) zugeordnet sind, der an einer Kante (9) der Glasplatte angeordnet ist, und der die Infrarotstrahlung in die Glasplatte einstrahlt, wo sie sich durch Totalreflexion ausbreitet.

2. Schalttafel nach Anspruch 1, dadurch gekennzeichnet, daß die Maske (3) auf der Rückseite der Glasplatte (1) aus einer Schicht eines lichtundurchlässigen eingebrannten Emails besteht.

3. Schalttafel nach Anspruch 2, dadurch gekennzeichnet, daß im Bereich der Fenster ein Infrarot-Filter angeordnet ist, der aus einer aufgedruckten Schicht (5), insbesondere einer Silberbeize, besteht, die auf der Rückseite eingebrannt ist.

4. Schalttafel nach Anspruch 3, dadurch gekennzeichnet, daß die Beschriftungen und Markierungen (2) aus einem weißen Email bestehen, das auf der Vorderseite aufgedruckt ist.

5. Schalttafel nach einem der Ansprüche 1 bis 4, dadurch gekennzeichnet, daß die Glasplatte (1) eine thermisch vorgespannte Silikatglasplatte ist, mit deren Oberfläche die lichtundurchlässige Schicht (3), die Filterschicht (5) und die Markierungen (2) durch gleichzeitiges Einbrennen während der für die Vorspannung notwendigen Wärmebehandlung verbunden sind.

6. Schalttafel nach einem der Ansprüche 1 bis 5, dadurch gekennzeichnet, daß gegenüber einer Kante der Glasplatte ein Sender für sichtbares Licht angeordnet ist, der die Markierungen durch Lichtstreuung beleuchtet.

7. Schalttafel nach Anspruch 6, dadurch gekennzeichnet, daß der Sender für sichtbares Licht gleichzeitig der Sender für die Infrarot-Strahlung ist.

**Claims**

1. Control board formed of a glass plate (1) provided with touch switches placed opposite printed marks (2) which indicate the touch-sensitive areas, said switches comprising semiconductor detectors sensitive to infra-red radiation, placed behind windows (4) transparent to infra-red radiation provided opposite said printed areas in a mask (3) on the rear surface of the glass plate, characterised in that at least one group comprising a plurality of detectors (6) is associated with the same infra-red emitter (7) placed opposite an edge (9) of the glass plate into the interior of which it injects infra-red radiation, which is propagated by total reflection.

2. Control board according to claim 1, characterised in that the mask (3) on the rear surface of the glass plate (1) is formed of a layer of opaque vitrified enamel.

3. Control board according to claim 2, characterised in that, on the windows, is placed an infra-red filter formed of a printed layer (5), in particular a silver cement, fired by a furnace on to the rear surface.

4. Control board according to claim 3, characterised in that the inscriptions and marks (2) are formed of a white enamel printed on the front surface.

5. Control board according to one of claims 1 to 4, characterised in that the glass plate (1) is a plate of thermally tempered silicate glass, at the surface of which the opaque layer (3), the filter layer (5) and the marks (2) are incorporated by firing at the same time during heat treatment for tempering.

6. Control board according to claims 1 to 5, characterised in that an emitter for visible light is positioned on its edge facing the edge of the glass plate to illuminate the marks by diffusion.

7. Control board according to claim 6, characterised in that it is the emitter for visible light which also forms the infra-red emitter.

**Fig. 1**

**Fig. 2**

0 025 763